# EUROPEAN PATENT APPLICATION

(11) **EP 0 676 913 A1**
(43) Date of publication of application: **11.10.1995**
(21) Application number: 95302330.6
(22) Date of filing: 07.04.1995
(51) Int. Cl.: H05K 3/34

(54) **Surface-mount component soldering**

(30) Priority: 08.04.1994 US 225263
(71) Applicant: VLT CORPORATION, San Antonio, Texas 78230 (US)
(72) Inventor: Balog, John S., Mendon, Massachusetts 01756 (US); Belland, Robert E., Nashua, New Hampshire 03060 (US)
(74) Representative: Deans, Michael John Percy

(57) **Abstract**

A circuit assembly is formed by placing a surface-mount component on a substrate with a termination of the component in the vicinity of a pad on a first surface of the substrate, and soldering the termination of the component to the pad by supplying molten solder from an opposite surface of the substrate.

A circuit structure may include a surface-mount component having a body and two terminations attached to the body, and a substrate having two pads exposed on a surface and apertures which extend through the two pads and through the substrate, the two terminations being soldered respectively to the two pads, each of the terminations occluding portions but not all of the apertures in the corresponding pads.

## Description

This invention relates to surface-mount component soldering.

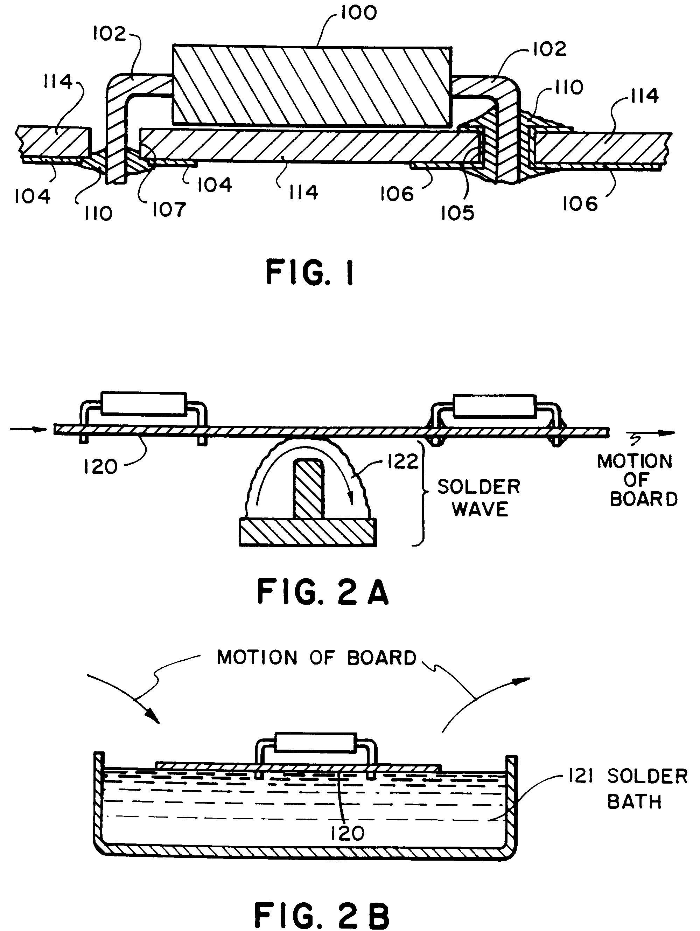

As seen in Figure 1, a through-hole electronic component 100 typically has conductive leads or pins (terminations) 102 for insertion into holes 105, 107 in a printed circuit board 114 (Figure 1). Terminations 102 are held by solder 110 to metallic pads or runs 104, 106 which may be on the surface of the board 114, on the interior surfaces of a hole 105, or both. Soldering may be done by hand with a soldering iron or automatically in a wave-solder machine. As seen in Figure 2A, in a wave-solder machine the side of the board 120 through which the terminations extend is passed over a wave of molten solder 122. Other ways of applying the molten solder include a solder bath 121 (Fig. 2B) or a solder fountain. Suppliers of wave-solder machines, solder baths, and solder fountains include Electrovert USA Corporation, Camdenton, MO, USA; Air-Vac Engineering Co, Inc., Milford, CT, USA; and Ideya Co., Ltd., Kyoto, Japan.

A wave-solder machine may also preheat the board and apply flux prior to soldering. The time during which the solder is in contact with the back of the board (e.g., as determined by how fast the board is passed over a wave), and the temperature of the solder, are adjusted to achieve a good solder connection.

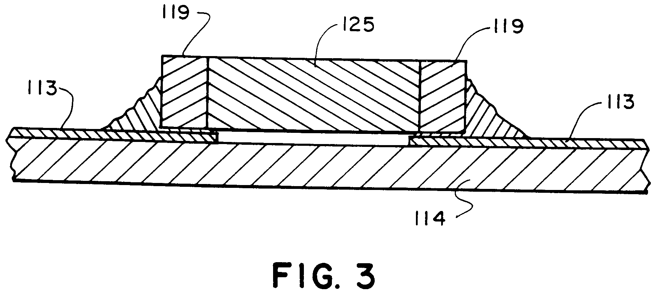

As seen in Figure 3, so-called surface-mount electronic components 125 have terminations 119 which lie directly on metal pads 113 on the surface of a board or substrate 114, rather than passing through holes in the board. During assembly, a controlled amount of solder paste is coated on the pads (e.g., with a screen printer). The components are then placed on the board with the terminations lying on the solder paste and pads. The board is then passed through a reflow oven.

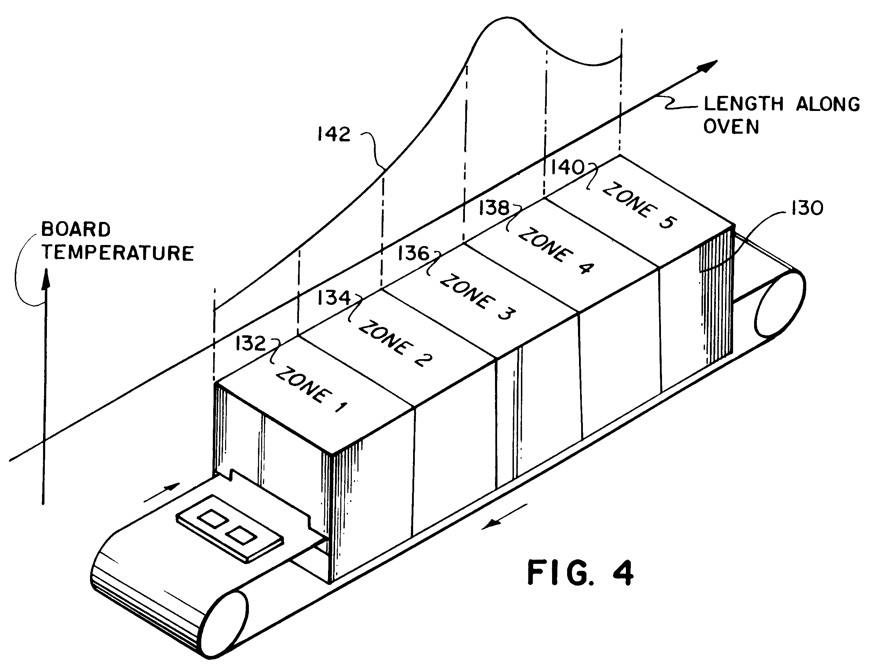

Referring to Figure 4, a typical reflow oven 130 includes a series of heat zones 132 through 140. Each heat zone may be adjusted to a selected temperature so that the series of heat zones defines a temperature profile 142 along the length of the oven. The speed of the board through the reflow oven and the temperature profile are adjusted to achieve good solder connections.

Electronic assemblies sometimes include a mix of through-hole and surface-mount components. For example, a DC-DC power converter may exploit the relatively small size of surface-mount components for control circuits and output capacitors while relying on through-hole connections for "odd form" transformers and inductors. Construction of such assemblies has typically involved a mix of processes.

In one approach the surface-mount components are soldered to the board first, using a reflow oven as described above. Then the through-hole components are assembled to the board and either soldered by hand or using a wave-solder machine.

In general, in one aspect of the invention a circuit assembly is formed by placing a surface-mount component on a substrate with a termination of the component in the vicinity of a pad on a first surface of the substrate, and soldering the termination of the component to the pad by supplying molten solder from an opposite surface of the substrate.

Implementations of the invention may include the following features: A solder flow path may be formed which extends from a solder originating position on the opposite surface of the substrate and through the substrate to an exposed soldering location in the vicinity of the pad. The path may be formed by an aperture through both the substrate and the pad. The termination may be placed to occlude part, but less than all of, the aperture. The component may be glued to the substrate to hold it in place for soldering. A through-hole component may be placed on the substrate by passing leads of the component through holes in the substrate prior to the soldering. Flux may be applied to the opposite surface and/or to the first surface before the soldering. The flux may be applied after placing the surface-mount component. The flux may be applied by a foam fluxer and may be redistributed by an air knife.

The substrate and the component may be preheated prior to the soldering. The soldering may be done using a solder bath or a solder wave.

The minimum aperture dimension may be 0.035" (0.0889 cm).

In general, in another aspect, the invention features a circuit structure including a surface-mount component having a body and two terminations attached to the body, a substrate having two pads exposed on a surface and apertures which extend through the two pads and through the substrate, the two terminations being soldered respectively to the two pads, each of the terminations occluding portions but not all of the apertures in the corresponding pads. Implementations may also include a through-hole component having a body and terminations which pass through holes in the substrate.

Advantages which accrue from practical implementations of our system may include the following:

Both through-hole and surface-mount components may be mounted on a substrate without requiring both wave and reflow soldering processes. This saves cost, requires less handling, and results in a shorter production cycle time. Components which might be damaged by traditional surface-mount reflow heating may be made in surface-mount packages and mounted without damage.

Other advantages and features will become apparent from the following description.

In the drawings:

Figure 1 is a side sectional view of a through-hole component soldered to a circuit board.

Figures 2A and 2B are schematic side views of wave and bath soldering, respectively.

Figure 3 is a side sectional view of a surface-mount component soldered to a circuit board.

Figure 4 is a schematic perspective view of a reflow oven for soldering surface-mount assemblies.

Figures 5A and 5B are a schematic perspective view and sectional side view of a surface-mount component ready for wave-soldering.

Figures 5C and 5D are sectional side views of soldered components.

Figures 6A, 6B, and 6C are top, side, and end views, respectively of a surface-mount component.

Figure 7 is a schematic top view of the component of Figures 6A, 6B, and 6C overlaid on pads.

Figures 8A, 8B, and 8C are top, side, and end views of another surface-mount component.

Figure 9 is a schematic top view of the component of Figures 8A, 8B, and 8C overlaid on pads.

Figures 10A and 10B are top and side views of a circuit board with components.

Figure 11 is a schematic view of a processing line.

Wave-soldering and reflow soldering expose components to different thermal environments. Reflow soldering tends to soak the entire component in an elevated ambient temperature environment for an extended period of time. Wave-soldering concentrates heat at the end of a component terminating lead for a relatively short period of time. During wave-soldering, the board (which can be any substrate having conductive runs to which components are soldered, e.g., a printed circuit board or ceramic substrate) acts as a thermal buffer between the hot solder wave and the bodies of the components.

Certain components, for example metallized polyester capacitors, are not considered suitable for assembly using surface-mount processes because they cannot withstand extended exposure to the temperature environment found in a reflow oven. As a result, these components are usually sold as through-hole components. On the other hand, there would be benefits to being able to buy these components with surface-mount terminations. First, they would be less costly (because terminating leads would not have to be attached). Second, in some applications there would be performance benefits. For example, surface-mount terminations would yield lower parasitic series inductance in the board interconnections and would minimize the potential for high-frequency ringing in switching applications.

In a DC-DC converter built on a printed circuit board, transformers and inductors may have through-hole terminations for several reasons. Such components are economical to make, do not require large conductive pads (and associated board area) which might otherwise be needed to carry large currents into and out of surface-mount terminations, and avoid the problem of incompatibility with reflow soldering which stems from their large physical or thermal mass.

On the other hand, surface-mount varieties of components such as tantalum output filter capacitors may be used because of their relatively small size.

Assembling and soldering both through-hole and surface-mount components on a circuit board is relatively costly, requires more handling, and results in a longer production cycle time than for assemblies which have only through-hole or only surface-mount parts. These disadvantages accrue because the process demands more production steps, heavier capital equipment investment (e.g., both a reflow oven and a wave-solder machine), and/or more intensive labor expenditures.

Using only wave-soldering to solder both through-hole and surface-mount parts to a board would thus achieve significant advantages.

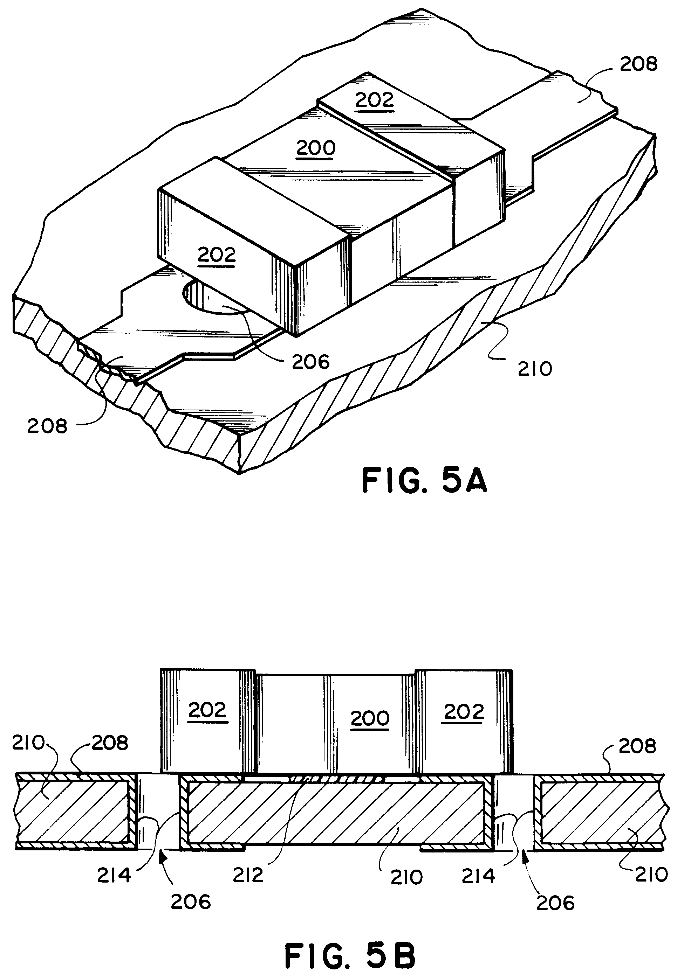

These advantages may be achieved by appropriate arrangement of a surface-mount component on a board as seen in Figures 5A and 5B.

Conductive terminations 202 on surface-mount component 200 lie on top of conductive pads 208 which are formed on the surface of substrate 210. Apertures 206 are located on each conductive pad 208 and pass all the way through the substrate. Conductive material 214 lines the inner surface of each of the apertures. The aperture locations are arranged so that, when the component 200 is placed onto the substrate, a portion of each aperture is under the conductive terminations 202 and a portion extends beyond the ends of the component 200. To prevent the component from becoming dislocated after placement, a small amount of adhesive 212 may be placed under the component just prior to its being placed on the substrate.

After the component is placed over the pads and apertures, the board undergoes a wave-soldering or equivalent process. First, solder flux is applied to both the top and the bottom of the board. The board is then preheated (to volatize thinners out of the flux and to reduce thermal shock when the assembly is soldered) and passed over molten solder (in the form, e.g., of a solder bath; solder wave; or solder fountain) so that the bottom side of the board faces the molten solder. As the apertures pass over the molten solder, the molten solder passes up through the apertures. The molten solder which passes through the apertures heats the conductive terminations 202 on the component and wicks up along the terminations themselves.

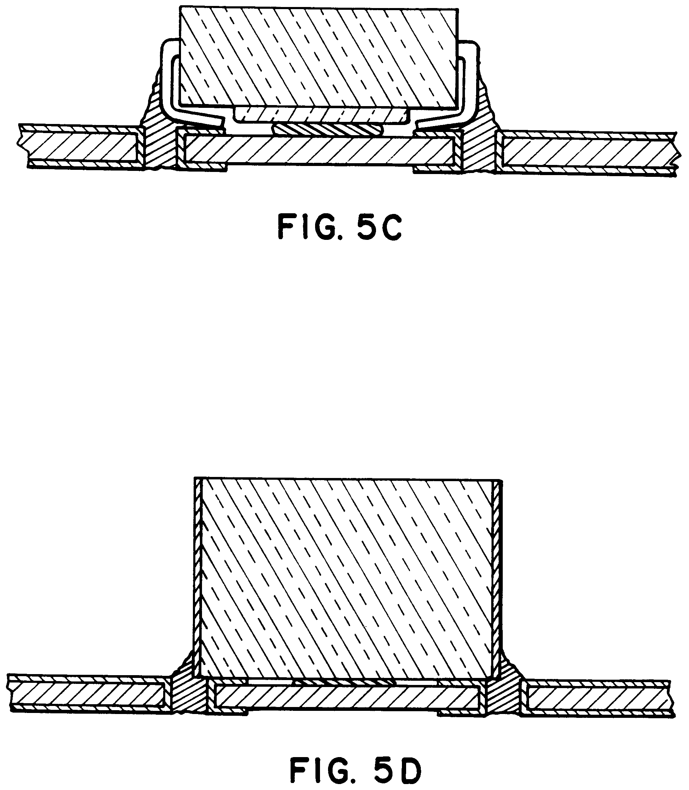

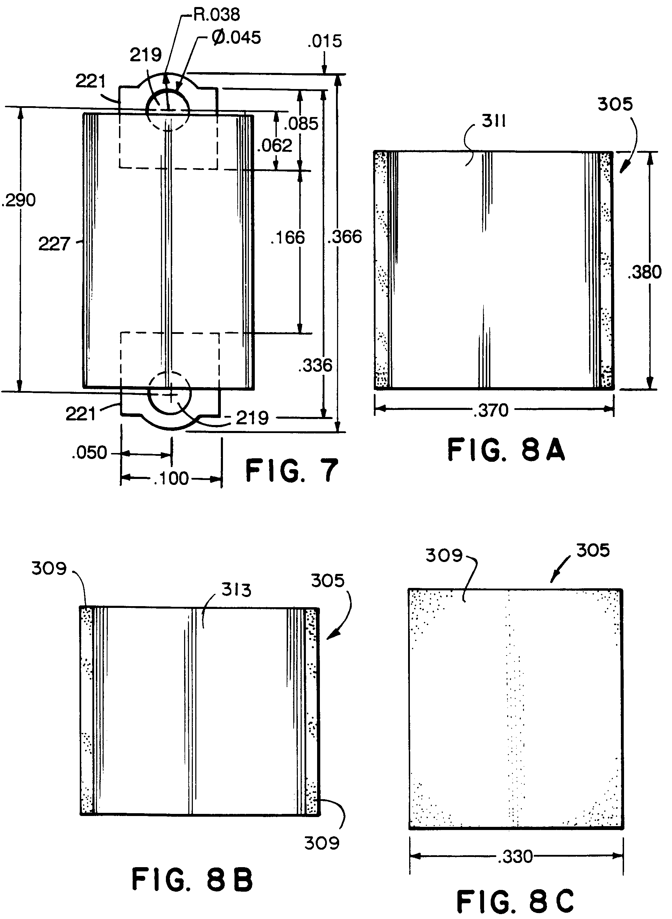

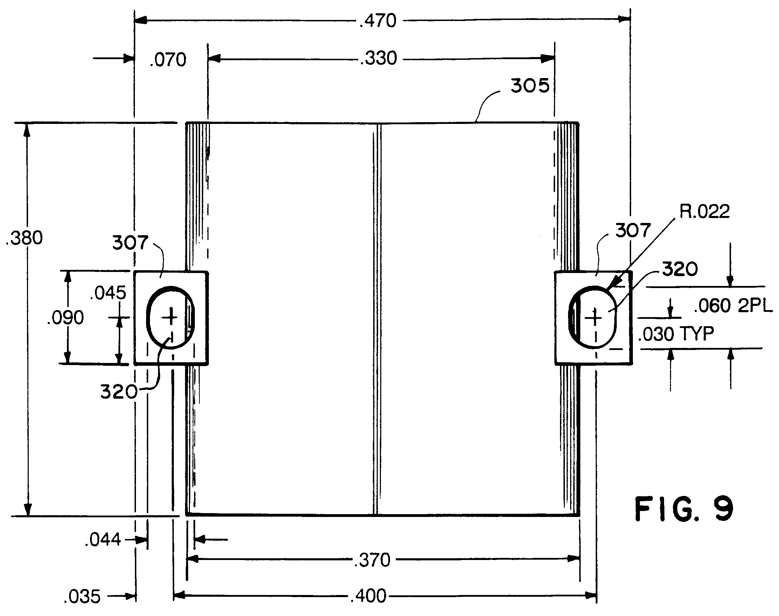

The resulting solder joints are illustrated in Figure 5C for a D-case component, and in Figure 5D for a component like the one of Figures 8 and 9 (discussed below).

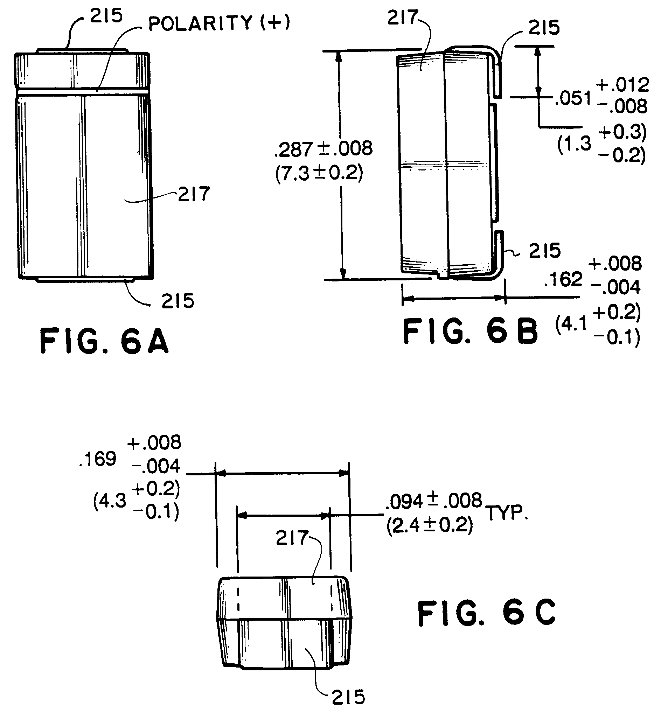

Referring to Figures 6A, 6B, and 6C, a standard "D-case" surface-mount package used, e.g., for packaging tantalum capacitors, has the dimensions shown. The conductive terminations 215 (copper with a tin/lead plating) are folded down along the ends of the molded epoxy package 217 and are bent underneath the ends of the package.

In Figure 7, the outline of the D-case 227 component is shown overlaid on a layout of pads 221 and circular apertures 219 (for use on an 0.030" - 0.0762cm - thick fibreglass printed circuit board clad with 2 ounce (56.7g) copper--e.g., copper of a nominal thickness of 0.003" - 0.00762 cm). The apertures are of 0.045" (0.1143cm) nominal internal diameter and the dimensions of the copper pads 221 surrounding the apertures are shown. The apertures 219 are plated through with copper (also of nominal 0.003" - 0.00762cm - thickness) which connect the pads on the top of the board to copper pads on the bottom surface of the board. The layout of the pads on the bottom surface of the board (not shown) may be the same as that shown for the pads in Figure 7, or they may be rings of copper etch of the same outer diameter as the outside radiused portion of the pads shown in Figure 7 (0.076" - 0.19309cm).

Referring to Figures 8 and 9, a different kind of surface-mount package 305 (useful, for example, for a surface-mount film capacitor) has terminations 309 made of a lead, antimony and copper alloy which is plasma-sprayed over the ends of the part during manufacture of the capacitor. There is relatively little overlap of the termination material onto surfaces which adjoin the ends (e.g., surfaces 311, 313). The apertures 320 in pads 307 are not circular, but are slots with radiused ends. This provides for a longer solder termination along the end of the part which reduces the electrical resistance of the joint. Apertures 320 are plated through with copper and connect to termination pads on the bottom of the printed circuit board which are essentially the same as those shown in Figure 9.

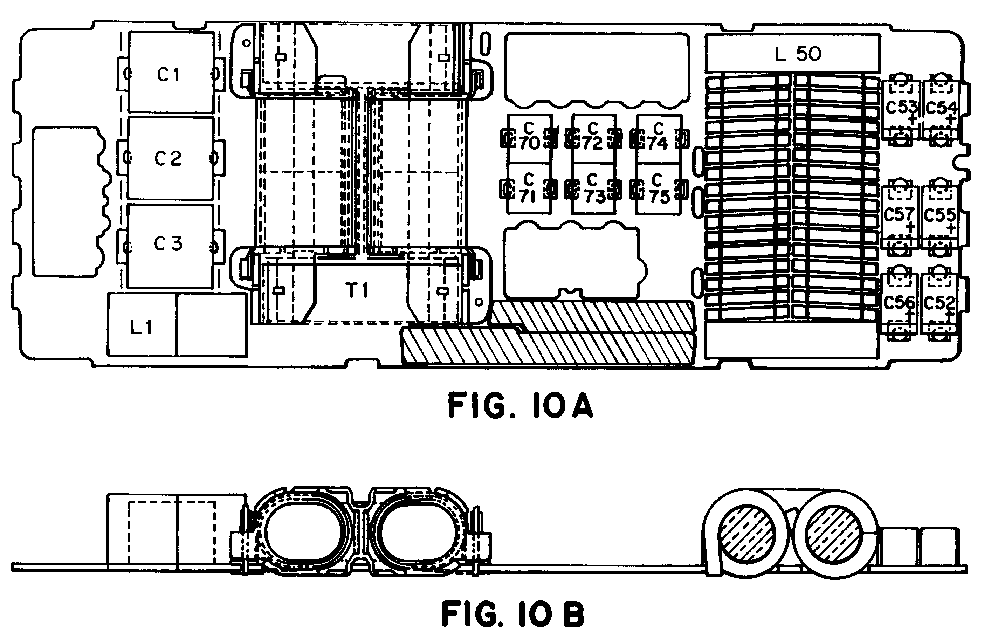

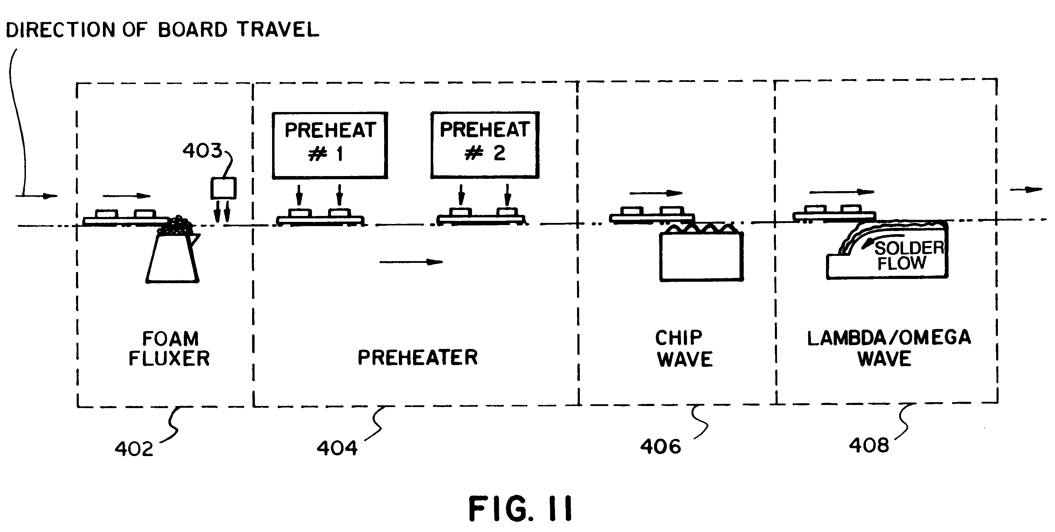

Referring to Figures 10 and 11, in one example of a circuit board assembly, components of the kinds shown in Figures 6A, 6B, and 6C (e.g., the ones labelled C52 through C57), and of the kinds shown in Figures 8A, 8B, and 8C (e.g., the ones labelled C1 through C3, and C70 through C75) were mounted with adhesive to a printed circuit board over termination pads of the kinds shown in Figures 7 and 9. The approximate overall dimensions of the printed circuit board were 1.59" x 4.4" (4.0386cm x 11.176cm). Other components, such as through-hole transformer T1 and through-hole inductors L1 and L50, were also mounted to the printed circuit board. The printed circuit assemblies were passed through an Electrovert "Econopak Plus" (Electrovert USA Corporation, Camdenton, MO, USA) wave-soldering system with the following installed options: a foam fluxer 402; dual-zone infrared preheaters 404; dual wave-solder modules (chip wave 406 and lambda/omega wave 408); and a nitrogen inerting system (not shown, but of the kind that is part of the soldering modules and bathes the surfaces of the waves with nitrogen to keep oxygen away). Lead clearance was set to 0.53 inches (1.3462cm). The solder used was a 63/67 Alpha Vaculoy and the flux used was Alpha SM351F No-Clean Flux, both manufactured by Alpha Metals, Jersey City, NJ, USA. The boards were passed through the wave-solder system at a speed of 4.0 feet(1.2192m)-per-minute. The foam fluxer was set to 400 RPM and adjusted to deposit flux on both the bottom and the top of the board assemblies. After fluxing, an air knife 403 positioned over the top of the board and set to its full-open setting and operated at 10 PSI (6.89 x 10⁴N/m²), provided for a thin and even redistribution of the topside flux and removal of excess flux.

After fluxing, the board assemblies were passed under the two infrared preheaters. The first zone was set to 450 C and the second zone to 480 C. This brought the top surface temperature of the board to approximately 100 degrees C. The boards were then passed over the chip wave (which is similar to a solder bath but with a rippling surface). The wave was set to a solder temperature of 500 F and to 1600 RPM. After passing through the chip wave, the boards passed over the Lambda/Omega wave. In a Lambda wave, the solder flows in a stream, much like water flowing over the top of a dam, and the bottom of the board impinges upon and moves through the surface of the stream; the Omega option imparts controlled vibration to a portion of the surface of the wave. Both the chip wave and the Lambda/Omega wave are designed to enhance the ease with which solder migrates into small spaces and into holes in the board and this helps to force solder up through the apertures and onto the end terminations on the surface-mount components. The solder temperature was 500 F, the Lambda wave was set to 1225 RPM, and the Omega wave set to 50%. Both waves were operated with a Nitrogen blanket (to prevent oxidation during the soldering process and improve wetting).

The soldered assemblies exhibited good solder flow up onto the end terminations of the surface-mount components on the top of the board and good quality solder joints.

Good solder joints will depend upon the degree to which molten solder will migrate up through the apertures provided and carry enough heat to the end terminations of the parts to ensure a good joint. Among the factors which affect this are the area and aspect ratio of the apertures and the thickness of the board. It is difficult, for example, to get solder to flow up through very narrow apertures. For a 0.030" (0.0762cm) thick board it was found that solder flow would diminish sharply if the minimum dimension of the aperture was less than about 0.035"(0.0889cm). Thicker boards would require larger openings as resistance to flow will increase with board thickness. On the other hand, higher preheat temperatures will give better results with smaller apertures since the cooling effect of the mass of the board assembly on the molten solder flowing through the aperture will be decreased. Quality of joints also depends on the quality of the contact between the end termination on the component and the pads on the board. Direct contact encourages good joints; gaps between the terminations and pads act as thermal barriers and diminish the quality of the joints. For the kinds of components cited above, and in particular the film capacitor which has end terminations which are coated over the surfaces of the part and do not have the compliance of the spring-like contact on the D-case package, the yield of good solder joints was reduced sharply as the gap between the metallic terminations and the pad on the board increased above about 0.003" (0.00762cm).

## Claims

1. A method of forming a circuit assembly comprising
placing a surface-mount component on a substrate with a termination of the component in the vicinity of a pad on a first surface of the the substrate, and
soldering the termination of the component to the pad by supplying molten solder from an opposite surface of the substrate.

2. A method according to Claim 1, further comprising
forming a solder flow path which extends from a solder originating position on the opposite surface of the substrate and through the substrate to an exposed soldering location in the vicinity of the pad.

3. A method according to Claim 2, wherein the path is provided by forming an aperture preferably with an aperture dimension of 0.035 inches (0.0889cm), through both the substrate and the pad.

4. A method according to Claim 3, wherein the termination is placed to occlude part, and preferably less than all, of the aperture.

5. A method according to any preceding claim, further comprising attaching the component, preferably by gluing, to the substrate to hold it in place for soldering.

6. A method according to any preceding claim, comprising the further step of placing a through-hole component on the substrate by passing leads of the through-hole component through holes in the substrate prior to the soldering step.

7. A method according to any preceding claim, further comprising applying flux, preferably by means of a foam fluxer, to the opposite surface and/or to the first surface before the soldering step, and preferably after placing the surface-mount component.

8. A method according to Claim 2, further comprising redistributing the flux, preferably by an air knife, after applying it.

9. A method according to any preceding claim, further comprising preheating the substrate and the component prior to the soldering.

10. A method according to any preceding claim, wherein the soldering step is done using a solder bath or a solder wave.

11. A circuit structure comprising;
a surface-mount component having a body and two terminations attached to the body;
a substrate having two pads exposed on a surface and apertures which extend through the two pads and through the substrate;
the two terminations being soldered respectively to the two pads, each of the terminations occluding portions but not all of the apertures in the corresponding pads.

12. A circuit structure according to Claim 11, further comprising a through-hole component having a body and terminations which pass through holes in the substrate.
